# EUROPÄISCHE PATENTANMELDUNG

(11) **EP 2 460 908 A1**
(43) Veröffentlichungstag der Anmeldung: **06.06.2012**
(21) Anmeldenummer: 10015282.6
(22) Anmeldetag: 03.12.2010
(51) Int. Cl.: C23C 28/00, C23C 28/02, C23C 30/00, C23C 14/06, C25D 5/12, C25D 7/00

(54) **Sanitägegenstand**

(71) Anmelder: Grohe AG, 58675 Hemer (DE)
(72) Erfinder: Rost, Axel, 77933 Lahr (DE); Musielik, Rene, 77963 Schwanau (DE); Ueckert, Ingrid, 77972 Mahlberg (DE)

(57) **Zusammenfassung**

Bei einem Sanitärgegenstand aus einem Substrat bestehend aus Metall oder Kunststoff und einer Beschichtung ist vorgesehen, aufeinanderfolgend Metallschichten aus Kupfer, einer Legierung aus Kupfer und Zinn und Chrom galvanisch abzuscheiden und anschließend eine Deckschicht aufzubringen, die aus wenigstens einem der Elemente Chrom, Titan, Zirkon, Gold, Silber oder Platin oder aus einer chemischen Verbindung der Elemente Titan oder Chrom mit Stickstoff und optional Kohlenstoff besteht, wobei die Deckschicht mittels eines PVD-Verfahrens auf der galvanisch abgeschiedenen Chromschicht hergestellt wird.

## Beschreibung

Die Erfindung betrifft einen Sanitärgegenstand gemäß dem Oberbegriff des Patentanspruchs 1 sowie ein Verfahren zu deren Herstellung gemäß Patentanspruch 8.

Die Erfindung betrifft Sanitärarmaturen und Installationsprodukte, Brauseköpfe, Ausläufe oder Rosetten und Abdeckplatten, die zum einen resistent gegenüber Korrosion, Reibung und chemischer Beanspruchung sein müssen und andererseits eine dekorative Oberfläche mit vorbestimmter Farbgebung aufweisen sollen. Aus dem Stand der Technik sind zahlreiche Verfahren zum Aufbringen dekorativer Schichten bekannt. Neben nasschemischen Verfahren wie galvanischen Prozessen sind Verfahren wie PVD (Physical Vapor deposition), CVD (Chemical Vapor Deposition) und Lackierverfahren sowie deren Kombinationen bekannt, mittels derer Schichten mit bestimmten Farbgebungen auf den Gegenständen abgeschieden werden können.

Bei Sanitärgegenständen aus Messing oder Kunststoff werden schon aus Kostengründen hauptsächlich galvanische Beschichtungen verwendet. Dabei wird üblicherweise eine Schicht aus einem nickelhaltigen und für die Deckschicht aus einem Chrom(VI)haltigen Elektrolyten abgeschieden.

Aufgrund von gesundheitlichen Aspekten und zunehmend strengeren Vorschriften, die die Qualität von Trinkwasser betreffen, werden jedoch diese herkömmlichen Schichten kritisch betrachtet.

Auch wenn Chrom(VI) in der Endschicht nach dem Verchromen nicht mehr nachweisbar ist, ist der Umgang mit den Bädern gefährlich, da Chrom(VI)-Verbindungen als äußerst giftig, krebserregend und erbgutschädigend bekannt sind.

Hinzu kommt, dass Nickel als Auslöser für Kontaktallergien gilt. Auch wenn die Nickelschicht bei Sanitärarmaturen keine Deckschicht darstellt, kann der Kontakt mit dem Trinkwasser unter Umständen zur Auslösung von Nickel führen, da die Chromschicht nicht an jeder Stelle deckend ausgeführt sein muss.

Zudem enthält das Grundmaterial für die Sanitärarmaturen, Messing, üblicherweise einen Zusatz von Blei, um die Zerspanbarkeit der Armaturenkörper bei der Bearbeitung nach dem Gießvorgang zu verbessern. Blei und Bleiverbindungen, die aus dem Messing herausgelöst werden, wirken ebenfalls toxisch auf den Menschen. Sie sind außerdem gefährlich, da sie sich über längere Zeiträume stetig eingenommen in den Knochen des Körpers einlagern können und zu chronischen Vergiftungen führen können.

Vor diesem Hintergrund liegt der Erfindung die Aufgabe zugrunde, Sanitärgegenstände herzustellen, bei welchen schädliche Emissionen soweit wie möglich reduziert sind. Unter Emission wird dabei der Austrag giftiger, gesundheitsschädlicher oder umweltgefährdender chemischer Stoffe, etwa Schadstoffe aller Art, Reizstoffen, Allergene etc. verstanden.

Diese Aufgabe wird durch einen Sanitärgegenstand mit den Merkmalen des Patentanspruchs 1 und einem Verfahren zur Herstellung von Sanitärgegenständen gemäß Anspruch 8 gelöst. Vorteilhafte Weiterbildungen sind Gegenstand von Unteransprüchen.

Mit der Erfindung wird ein Sanitärgegenstand mit einem Grundkörper aus einem Substrat bereitgestellt, das mit einer dekorativen Beschichtung versehen ist, wobei das Substrat aus Kunststoff oder Metall, insbesondere Messing, Aluminium, Zink oder Edelstahl, und die Beschichtung aus einer Schichtfolge aus Metallschichten, die mittels galvanischer Verfahren und PVD-Verfahren hergestellt werden, besteht. Unter Beschichten wird das Aufbringen einer fest haftenden Schicht aus formlosem Stoff auf ein Werkstück verstanden. Beschichtung und Substrat bilden einen Verbundkörper aus unterschiedlichen Stoffen. Die Beschichtung übernimmt die Kontaktfunktion, wie Schutz gegen chemischen oder korrosiven Angriff und gegen Tribobeanspruchung, beeinflusst das Reibverhalten oder dient optischen oder dekorativen Zwecken, während das Substrat die Tragfunktion übernimmt, wobei seine Eigenschaften der spezifischen Beanspruchung ohne Rücksicht auf das Kontaktverhalten angepasst werden können.

Mit der Erfindung wird somit ein Sanitärgegenstand aus einem Substrat aus Metall oder Kunststoff und einer galvanischen Beschichtung bereitgestellt, die aufeinanderfolgende Metallschichten umfasst. Als erste Schicht ist Kupfer, als zweite Schicht eine Legierung aus Kupfer und Zinn und als dritte Schicht Chrom vorgesehen. Weiterhin weist die Beschichtung eine Deckschicht bestehend aus wenigstens einem der Elemente Chrom, Titan, Zirkon, Gold, Silber oder Platin oder aus einer chemischen Verbindung der Elemente Titan oder Chrom mit Stickstoff und optional Kohlenstoff auf, die mittels PVD-Verfahrens auf der galvanisch abgeschiedenen Chromschicht hergestellt wird.

Hier kann beispielweise eine Chromschicht, eine Chrom-Nitrid-Schicht, eine Titan-Carbo-Nitrid-Schicht oder eine Edelstahlschicht als Deckschicht vorgesehen werden.

Gemäß einer vorteilhaften Ausgestaltung der Erfindung weist die zweite Metallschicht, die aus einer Legierung aus Kupfer und Zinn besteht, ein definiertes Mischungsverhältnis auf. Vorzugsweise ist dabei ein Legierungsverhältnis von 40-60 % Kupfer und 60-40 % Zinn vorgesehen Vorzugsweise wird die galvanische Chromschicht aus einem Chrom(III)haltigen Elektrolyten abgeschieden, sodass der Umgang mit Chrom(VI) vermieden werden kann.

Eine Ausführungsform der Erfindung sieht vor, dass das Substrat des Sanitärgegenstandes aus Messing besteht. Hierbei kommt vorzugsweise eine bleifreie oder bleireduzierte Legierung mit den Hauptlegierungsbestandteilen Kupfer und Zink zum Einsatz. In Verbindung mit der erfindungsgemäßen Beschichtung des Substrates ist es somit möglich, einen Sanitärgegenstand herzustellen, bei dem sowohl bei der Herstellung als auch bei der Benutzung Einflüsse durch gesundheitsgefährdende Stoffe nahezu beseitigt sind.

Das Verfahren zur Herstellung der erfindungsgemäßen Sanitärgegenstände aus Substraten wie Metall oder Kunststoff und deren dekorativen metallischen Oberflächen weist dabei folgende Verfahrensschritte auf. Zunächst wird der Sanitärgegenstand mittels eines Gießverfahrens oder Spritzgießverfahrens aus dem Substrat hergestellt. Anschließend wird das geformte Substrat bearbeitet, gereinigt und für die Beschichtung vorbereitet. Zunächst werden die galvanischen Metallschichten auf das Substrat aufgebracht. Auf die erste Metallschicht aus Kupfer folgt zur Farbgebung des Sanitärgegenstandes eine Metallschicht, die aus einer Legierung aus Kupfer und Zinn, der sogenannten Weißbronze, besteht. Die Weißbronzeschicht ersetzt dabei die sonst übliche Nickelschicht, die ansonsten zum Erreichen der gewünschten "Chromfarbe" dient. Im Anschluss daran wird auf das Substrat eine galvanische Chromschicht aufgebracht. Damit ist die galvanische Beschichtung abgeschlossen. Als Decksicht folgt eine Schicht aus wenigstens einem der Elemente Chrom, Titan, Zirkon, Gold, Silber oder Platin oder aus einer chemischen Verbindung der Elemente Titan oder Chrom mit Stickstoff und optional Kohlenstoff, die im PVD-Verfahren aufgebracht wird. Die abschließende Deckschicht wird dementsprechend auch als Hartstoffschicht bezeichnet.

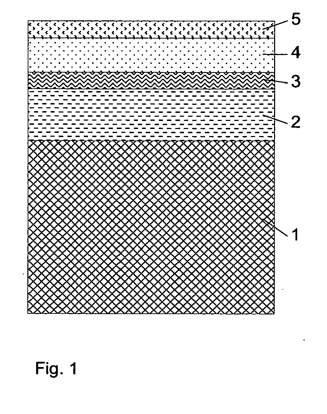

Ausführungsbeispiele der Erfindung sind in der Zeichnung dargestellt und werden im Folgenden näher beschrieben. In den Zeichnungsunterlagen bezeichnen gleiche Bezugszeichen gleiche Schichten. Es zeigt in der Zeichnung die
- Figur 1: einen Schnitt durch einen erfindungsgemäßen Schichtaufbau eines Sanitärgegenstandes.

Bei einem Sanitärgegenstand ist das Substrat aus bleifreiem Messing 1 beispielsweise als Gusskörper vorgesehen. Um eine hochglänzende korrosionsbeständige Oberfläche zu erzeugen, wird der Gusskörper zunächst galvanisch beschichtet. Hierbei werden nacheinander zunächst Kupfer 2, eine Legierung 3 aus Kupfer und Zinn und anschließend eine Chromschicht 4 unter Berücksichtigung der nötigen Zwischenschritte und Spülvorgänge abgeschieden. Die abschließende Deckschicht 5 oder Hartstoffschicht beispielsweise aus Titannitrid wird im Gegensatz dazu mittels eines PVD-Verfahrens in einer Vakuumkammer aufgebracht.

### Bezugszeichenliste

- 1: Messing (bleifrei)
- 2: Kupfer
- 3: Weißbronze (Legierung aus Kupfer und Zinn)
- 4: Chrom (galvanisch abgeschieden)
- 5: Deckschicht (mittels PVD-Verfahren hergestellt)

## Patentansprüche

1. Sanitärgegenstand aus einem Substrat und einer Beschichtung im Wesentlichen umfassend:
- ein Substrat bestehend aus Metall oder Kunststoff,
- eine galvanische Beschichtung mit aufeinanderfolgenden Metallschichten aus
- - Kupfer
- - einer Legierung aus Kupfer und Zinn
- - Chrom
und
- eine Deckschicht bestehend aus wenigstens einem der Elemente Chrom, Titan, Zirkon, Gold, Silber oder Platin oder aus einer chemischen Verbindung der Elemente Titan oder Chrom mit Stickstoff und optional Kohlenstoff, welche mittels eines PVD-Verfahrens auf der galvanisch abgeschiedenen Chromschicht hergestellt wird.

2. Sanitärgegenstand nach Anspruch 1, **dadurch gekennzeichnet, dass** die zweite, aus einer Legierung aus Kupfer und Zinn bestehende Schicht in einem definierten Mischungsverhältnis, vorzugsweise mit 60 % Kupfer und 40 % Zinn, vorgesehen ist.

3. Sanitärgegenstand nach Anspruch 1 oder 2, **dadurch gekennzeichnet, dass** die galvanische Chromschicht aus einem Chrom(III)haltigen Elektrolyten abgeschieden wird.

4. Sanitärgegenstand nach einem der vorhergehenden Ansprüche, **dadurch gekennzeichnet, dass** das Substrat aus Messing, Zink, Edelstahl oder Aluminium besteht.

5. Sanitärgegenstand nach Anspruch 4, **dadurch gekennzeichnet, dass** eine bleifreie oder bleireduzierte Legierung mit den Hauptlegierungsbestandteilen Kupfer und Zink vorgesehen ist.

6. Verfahren zur Herstellung von Sanitärgegenständen aus Substraten aus Metall oder Kunststoff mit dekorativen metallischen Oberflächen mit den Verfahrensschritten:
- Beschichten eines Substrats mit einer ersten Metallschicht aus Kupfer
- Beschichten des Substrats mit einer zweiten galvanischen Metallschicht, die aus einer Legierung aus Kupfer und Zinn besteht
- Beschichten des Substrats mit einer galvanischen Chromschicht
- Beschichten des Substrats mit einer Deckschicht im PVD-Verfahren.

7. Verfahren nach Anspruch 6 , **dadurch gekennzeichnet, dass** als Substrate für die Sanitärgegenstände Teile, Armaturenkörper oder Wasser führende Körper vorgesehen sind, die im Gießverfahren, im Spritzgießverfahren, mittels Stanzen, Pressen oder Tiefziehen hergestellt sind.
